# EUROPEAN PATENT APPLICATION

(11) **EP 0 989 388 A2**
(43) Date of publication of application: **29.03.2000**
(21) Application number: 99307553.0
(22) Date of filing: 24.09.1999
(51) Int. Cl.: G01D 18/00

(54) **Programmable digital meters**

(30) Priority: 24.09.1998 GB 9820695
(71) Applicant: London Electronics Limited, Shefford, Bedfordshire SG17 5QB (GB)
(72) Inventor: Laming, Graham, Meppershall, Bedfordshire SG17 5LU (GB); Karslake, Robert James, Shillington, Bedfordshire SG5 3LJ (GB)
(74) Representative: W.P. THOMPSON & CO.

(57) **Abstract**

A digital calibration technique intended for use with digital indicators provides an improvement in simplicity of calibration and simplification of operating instructions. In addition, this technique permits the user to see simultaneously the variable available for adjustment and an annunciation identifying that variable. In addition, the technique allows the user directly to select certain parameters for adjustment without having to proceed through a menu structure. In addition, this technique allows the digital indicator to, be used in any country, using any language script, by selecting the text type for the front fascia. The user can perform a calibration on the meter without needing to know the absolute value of the applied electrical signal, if this is derived from a sensor or transducer and if the magnitude of the applied physical variable acting on that sensor or transducer is known. The meter comprises a display window (28), inscribed pushbutton controls (34) each having at least a primary and a secondary function, and annunciator lights (36) indicating which parameter is being changed.

## Description

This invention relates to improved methods of calibrating programmable digital meters, and to programmable digital meters which can be calibrated using these methods. The invention is applicable not only to meters which just have a basic display function, but also to meters which have output facilities, such as alarms, analogue retransmission, serial data, etc.

Digital meters have been used for many years in manufacturing and testing environments, for indicating physical variables such as temperature, pressure, flow, voltage, current, etc. The meter receives electrical signals from a sensing device, and these signals must be processed by the meter so that the digital read-out relates directly to the measurement being made. For example, an electrical signal of 4-20 mA from a pressure sensor may relate to a pressure measurement range of 0 to 150 bar.

Traditionally, the calibration and adjustment of meters of this type was achieved by the use of potentiometers. This was a relatively simple task but was limited in terms of the precision which could be achieved.

More recently, with the advent of the microprocessor, programmable calibration using a simple keyboard has become popular. This offers greater precision and stability. However, the versatility of microprocessors has led to the evolution of digital panel meters which are so complicated to set up that they require a great deal of 'learning' by the user before they can be used properly. In general, users prefer not to follow through this learning process, but instead rely on technical support lines provided by meter manufacturers. This can be a great drain on the resources of the manufacturer. Also, users often bemoan the awkward nature of these methods of programmable calibration and the vast operating manuals which are required to enable calibration to be performed.

The problems or difficulties faced by a person seeking to calibrate a contemporary programmable digital meter can be considered under four general headings, as follows:
1. Conventional techniques of calibration often rely upon prompts which are generated by a 7-segment display on the meter. Because 7-segment displays are not well suited to displaying alphabetic characters, the interpretation of the prompts is often difficult to determine. Even more challenging is the situation where the meter is to be exported to a country where 7-segment representations of characters are completely inadequate, for example Arabic, Chinese, Japanese, etc.
   Alternatively, the known techniques may rely upon prompts which are generated by alphanumeric displays on the meter. However, the number of characters which are required to provide a clear prompting instruction may exceed the number of characters which may be reasonably provided on the front panel, bearing in mind cost and physical space restraints. This again results in a loss of clarity of the prompt so far as the user is concerned.
2. Conventional calibration techniques are often incorporated as part of a comprehensive setup menu, relating to other variable parameters. This therefore makes it awkward for the user to locate the correct part of the menu easily. Also the user will often have difficulty in determining where he is in the menu at any time, which can lead to confusion.
3. The conventional setting up procedures using complex menus are often quite different in concept to those employed in potentiometric calibration, which most users will be very familiar with. This therefore requires a different appreciation of the calibration routine, and this can take a considerable time to learn.
4. Conventional digital calibration techniques often rely upon internally stored calibration data, which relate to idealised expected signals from the sensor. This can give rise to errors in calibration if the sensor itself has poor inherent precision, as the sensor may not generate exactly the signals which are expected.

In WO93/07601 there is described a calibration system for measurement instruments, the calibration system comprising a two button system, one button being used to set each end of a range of values to be transmitted by a remote signal, thus setting the calibration and span of the signal. The buttons can be used to enter currently displayed values, or by pressing both buttons at once, setting modes can be entered in which one button increases and the other button decreases a displayed value of a parameter to be entered.

It is an object of the present invention to provide an improved method of calibration and scaling for programmable digital meters which is much simpler than conventional methods and which overcomes or at least substantially reduces the problems which arise from conventional techniques as outlined above.

It is a further object of the present invention to provide an improved method of calibrating programmable digital meters which is essentially intuitive in nature. The greater part of the simple menu is printed on the front panel of the meter, which greatly reduces the amount of extra instruction information to be supplied with the meter. The effect is to make the calibration routine intuitive to the user, based on the information presented on the front panel.

It is a further object of the invention to provide a method of calibrating programmable digital meters which minimises the complexity of the menu structure and provides clear prompts for the user to follow. The method of calibration is similar to the known analogue potentiometer type of calibration, but benefits from the dramatic increase in accuracy and stability which is provided by digital calibration.

It is yet a further object of the invention to provide a programmable digital meter which can be calibrated by the method of the invention.

In accordance with the invention there is provided a digital meter comprising an input arranged to receive electrical signals from sensing means, processing means arranged to respond to said signals to produce a digital read-out of parameters which relate to the measurement being made, and a panel comprising a display window for the read-out, a plurality of prompt controls operation of which enables the user to follow a calibration routine or carry out adjustment using the read-out in the display window, and annunciator means arranged to indicate which parameter is currently being changed.

Also in accordance with the invention there is provided a method of calibrating and/or adjusting a digital meter which is responsive to a physical variable to be monitored by sequentially displaying a value indication of parameters of the current condition of the variable, which comprises feeding electrical signals from sensing means to an input of the meter, operating prompt controls to follow a calibration routine or carry out adjustment using a digital read-out in a display window of the meter, and monitoring which parameter is currently being changed by using annunciator means respectively associated with different parameters.

In order that the invention may be more fully understood, one presently preferred embodiment of digital meter in accordance with the invention, and the method by which it is calibrated and adjusted, will now be described by way of example and with reference to the accompanying drawings. In the drawings:
Figure 1 is a front view of a digital meter in accordance with the invention and illustrates how this is incorporated into a typical digital meter system;
Figure 2 is a schematic block diagram showing the features of the digital meter of Figure 1; and
Figure 3 shows an alternative front panel layout for a digital meter in accordance with the present invention.

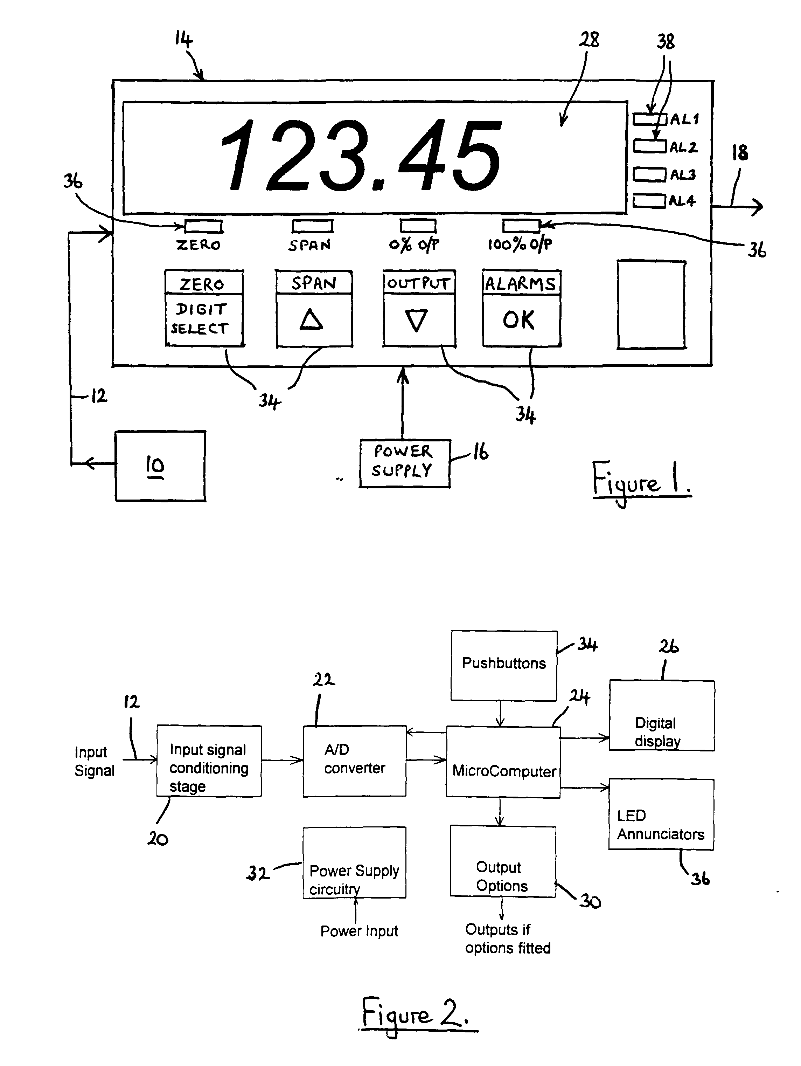

Referring first to Figure 1, this shows a typical digital meter installation in schematic terms. The installation comprises a device 10, for example a sensor, which generates a variable electrical signal which is transmitted over a line 12 to the digital meter which is indicated generally at 14. The value of the variable electrical signal at any time will depend in some way on a physical variable which is acting on the device 10. That physical variable can be for example temperature, pressure, flow rate, etc. and the sensor will be a device appropriate to measure that variable. The digital meter 14 receives the variable electrical signal on line 12 and, by way of a capability of scaling and off-setting the signal, will generally display a figure which relates directly to the physical variable itself, be it temperature, pressure, flow rate, etc, rather than simply displaying the absolute magnitude of the variable electrical signal. However, the latter requirement does sometimes arise and the present invention encompasses that possibility also.

The digital meter 14 is connected to a suitable power supply 16. In an alternative embodiment, depending upon the circumstances, the display may derive its power directly from the variable electrical signal itself.

In its most basic form, the digital meter 14 acts only as a display device. However, it is often a requirement that the meter shall also provide output signals, indicated by the output line 18. These outputs may take various forms. For example, they can comprise alarm signals which become effective when a predetermined value is reached. They can also be analogue or digital output signals which are proportional to the physical variable being measured, which signals can then be fed to other ancillary equipment.

An important feature of the invention is that the method of calibration permits the user of the digital meter to scale the incoming electrical signal easily, so that the displayed value throughout the range of the signal relates directly to the physical variable which is being monitored. Figure 2 of the drawings shows schematically the components of the digital meter which enable this method to be performed.

As shown in Figure 2, the input signal on line 12 is fed to an input signal conditioning stage 20. The output of this is fed to an analogue to digital converter 22. This may be a discrete self-contained stage, or may be part of a microcomputer 24. The microcomputer 24 accepts the digital data from the analogue to digital converter 22 and performs operations on this data to drive a digital display 26 which appears in the window 28 of the meter 14. The indication which appears in the window 28 correlates to the physical variable which is being measured. In addition, the microcomputer 24 can perform further computations to allow output signals to be generated from output option circuitry 30,if fitted. A power input and power supply circuitry for the meter is indicated generally at 32.

The microcomputer 24 has the capability of accepting signals from push buttons 34 on the front panel of the meter which are actuated by the operator during the calibration operation. The microcomputer 24 or its external memory device or devices contain the operating software which determines the calibration technique of the present invention which permits the meter easily to be scaled. To aid the operator, LED annunciators 36 are provided on the front panel of the meter to prompt certain actions from the operator and to indicate in which part of the setup procedure the meter is currently active. Figure 1 also shows a series of four alarm status annunciators 38, marked AL1, AL2, AL3 and AL4, which are optional and are shown here as an example of additional features only. Further reference will be made to these later.

The method of calibrating the digital meter shown in the drawings will now be described.

The primary requirements for the successful calibration of a digital meter are to adjust the 'ZERO' (reading at minimum range of input) and the 'SPAN' (reading at maximum range of input). These two parameters will define two points on a straight-line graph, between which the response of the meter will be assumed to be linear. In certain cases, the response of the meter may be required to be non-linear, for which additional techniques may be employed.

The ease and precision with which the ZERO and SPAN calibration points can be set will influence the attractiveness of the product to the user. As mentioned above, a very simple way of setting these points is by the use of potentiometers, but this method is limited in its accuracy and its long-term stability by the resolution and stability of the potentiometers themselves.

As shown in Figure 1, the four active parameter annunciators 36 are marked ZERO, SPAN, 0%O/P and 100% O/P respectively. These are each LED indicators. Four push buttons 34 are provided. Each push button has a primary function, as printed at the top of the button, and a secondary function, as printed at the bottom of the button. These functions are as follows:

### Primary Function

- Button 1: 'ZERO': when pressed, the meter will allow the user to trim the display's reading with a low level input applied. The 'ZERO' annunciator 36 will illuminate to signify that this parameter has been selected.
- Button 2: 'SPAN': when pressed, the meter will allow the user to trim the display's reading with a high level input applied. The 'SPAN' annunciator 36 will illuminate to signify that this parameter has been selected.
- Button 3: 'OUTPUT': when pressed, the meter will allow the user to trim the display's low level and high level analogue output levels. The '0% O/P' or '100% O/P' annunciator 36 will illuminate to signify which parameter has been selected.
- Button 4: 'ALARMS': when pressed will allow the user to view existing alarm settings and to alter them if required. The 'AL1', 'AL2', 'AL3', 'AL4' annunciators 38 will illuminate to signify which parameter has been selected.

### Secondary Function

- Button 1: 'DIGIT SELECT': when pressed in a setup routine this will allow the user to select any digit of the displayed value. The selected digit will be made apparent by some means, either by having its brightness contrasting against the others, by flashing, by its colour changing, or some other means. When selected, a digit may be altered.
- Button 2: 'UP ARROW': when a digit has been selected, its value may be increased in value by pressing the 'UP ARROW' button.
- Button 3: 'DOWN ARROW': when a digit has been selected, its value may be decreased in value by pressing the 'DOWN ARROW' button.
- Button 4: 'OK': when a parameter has been adjusted to the satisfaction of the user, the change will be stored in the memory of the meter by pressing the 'OK' button.

Thus, as an example, in order to calibrate the ZERO of the display in window 28, the user will progress through the following sequence of steps:
(i) Apply low level signal
(ii) Press 'ZERO' button'
(iii) Use 'DIGIT SELECT' and 'UP'/'DOWN' buttons to obtain desired reading
(iv) Press 'OK' when satisfactory

There now follows a more detailed description of certain typical calibration and adjustment procedures in accordance with the invention. The left-hand column sets out the actions desired by the user and the right-hand column sets out the method steps to be used to achieve that result.

| Action Desired | Method |
|---|---|
| Calibrate Zero Reading | Apply low level input signal and press 'ZERO' button. The ZERO annunciator will illuminate to confirm your choice. Determine what desired reading should be on the display. |
| | Select digits to amend using 'DIGIT SELECT' button, and increase or decrease selected digits using the 'UP ARROW' or 'DOWN ARROW' keys until the display reads as desired. Press OK when reading matches desired value. |
| Calibrate Span Reading | Apply high level input signal and press 'SPAN' button. The SPAN annunciator will illuminate to confirm your choice. Determine what desired reading should be on the display. Select digits to amend using 'DIGIT SELECT' button, and increase or decrease selected |
| Decimal point position | digits using the 'UP ARROW' or 'DOWN ARROW' keys until the display reads as desired. Continued use of DIGIT SELECT will cause the decimal point to flash, which may now be positioned as required. |
| | Press OK when reading matches desired value. |
| Calibrate analogue O/P | Press the OUTPUT button. The 0% O/P annunciator will illuminate to confirm your choice. By pressing DIGIT SELECT and the UP ARROW and DOWN ARROW keys, set the display to the value you would like to generate 0% analogue O/P. Press OK when done. Now the 100% O/P annunciator will illuminate. By pressing DIGIT SELECT and the UP ARROW and DOWN ARROW keys, set the display to the value you would like to generate 100% analogue O/P |
| Alarm levels and actions | By pressing the ALARMS button momentarily, you can check to see what the existing alarm levels and actions are for each of the 4 alarms. An annunciator will let you know which alarm's parameters you are viewing at any time. To amend an alarm, press the ALARMS button for more than 2 seconds. Use DIGIT SELECT and the UP ARROW and DOWN ARROW keys to amend an alarm's value. The left-hand digit in the alarm reading determines the alarm action |
| | H=High, L=Low, O=Off |

Other variable parameters may be incorporated into the display, using similar techniques of adjustment as described above.

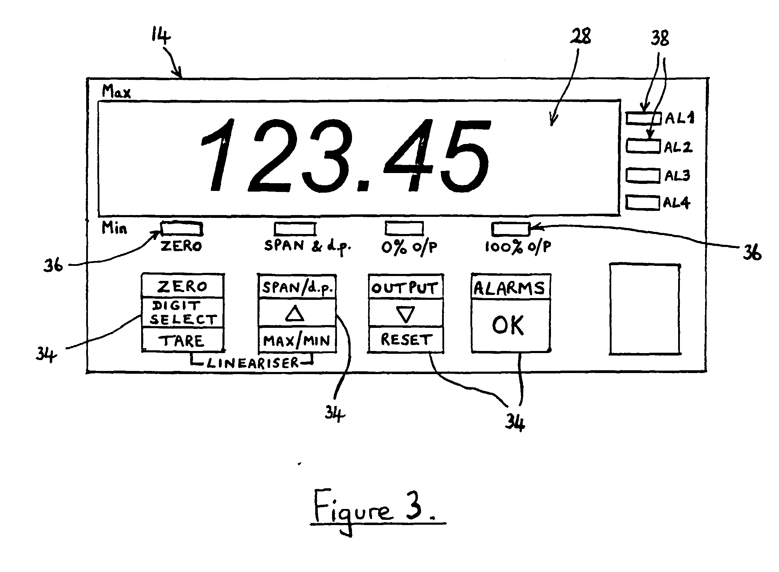

Figure 3 shows an alternative embodiment in which some of the buttons 34 have a tertiary function. The four active parameter annunciators 36 are as in Figure 1.

Each pushbutton 34 has a primary function, printed at the top of the button as follows:
- Button 1: 'ZERO': when pressed, the meter will allow the user to trim the display's reading with a low level input applied. The 'ZERO' annunciator 36 will illuminate to signify that this parameter has been selected.
- Button 2: 'SPAN': when pressed, the meter will allow the user to trim the display's reading with a high level input applied. The 'SPAN' annunciator 36 will illuminate to signify that this parameter has been selected.
- Button 3: 'OUTPUT': when pressed, the meter will allow the user to trim the display's low level and high level analogue output levels. The '0% O/P' or '100% O/P' annunciator 36 will illuminate to signify which parameter has been selected.
- Button 4: 'ALARMS': when pressed will allow the user to view existing alarm settings and to alter them if required. The 'AL1', 'AL2', 'AL3', 'AL4' annunciators 38 will illuminate to signify which parameter has been selected.
- Buttons 1 & 2: together 'LINEARISER': allows the user to set discrete calibration points at intervals along an input range to generate a nonlinear function.
Each pushbutton 34 has a secondary function, printed in the middle of the button, as follows:
- Button 1: 'DIGIT SELECT': when pressed in a setup routine this will allow the user to select any digit of the displayed value. The selected digit will be made apparent by some means, either by having its brightness contrasting against the others, by flashing, by its colour changing, or some other means. When selected, a digit may be altered.
- Button 2: 'UP ARROW': when a digit has been selected, its value may be increased in value by pressing the 'UP ARROW' button.
- BUTTON 3: 'DOWN ARROW': when a digit has been selected, its value may be decreased in value by pressing the 'DOWN ARROW' button.
- Button 4: 'OK': when a parameter has been adjusted to the satisfaction of the user, the change will be stored in the meter's memory by pressing the 'OK' button.

Three of the buttons 34 have a tertiary function printed at the bottom of the button. These functions are enabled only when the programming function of the display is disabled, by way of a rear panel jumper. These functions are TARE, to reset the displayed value to zero, regardless of input signal, MAX/MIN, to display the highest and lowest levels of input signal measured since the meter was last reset, and RESET, to clear any taring and clear the minimum and maximum registers. These functions may be altered in dependence upon a particular application.

Mention was made above of the fact that contemporary digitally calibrated meters encounter difficulties under four general headings (1) to (4). It will be appreciated from the foregoing description that these difficulties are overcome by the method and by the digital meter of the present invention, as follows:
(1) The digital meter of the present invention provides prompts by way of illuminated annunciators, associated with printed text, to show the user which parameter he is currently dealing with. As the printed text can be generated in any font or linguistic characters, the limitations associated with using 7-segment displays are eliminated. Thus, the meter could be set up for an English speaker, an Arabic speaker, a Chinese speaker, etc., with the overlay itself determining the targeted linguistic group.
(2) The annunciators 36 are arranged in a line. The first parameter activates the first annunciator, and one moves along the line as the user proceeds through the setup routine. This means that the user can see at a glance where in the routine he is at any time. He also has the freedom to go to the third parameter directly, without first having to pass through the first and second parameters.
(3) The routine which is followed by the user has been designed to mimic the steps which were involved in performing a potentiometric calibration, but, rather than potentiometers being used, up/down push buttons provide the adjustment method and clearly annotated push buttons allow the user to select zero calibration or span calibration. The annunciators light up to confirm to the user that he is in the zero or span calibration routine.
(4) The routine in accordance with the invention monitors the actual signals which are generated by the sensor 10. The absolute values of these do not need to be known by the user. The user simply adjusts the meter 14 to display a desired reading at both ends of the calibration range, and the meter will measure and store the values of the signal being generated by the sensor at those points. All the user needs to know is what display value he would like to see for a given physical condition acting on the sensor or other device which is generating the electrical input signal.

## Claims

1. A digital meter comprising an input arranged to receive electrical signals from sensing means, processing means arranged to respond to said signals to produce a digital read-out of parameters which relate to the measurement being made, and a panel comprising a display window for the read-out, a plurality of prompt controls operation of which enables the user to follow a calibration routine or carry out adjustment using the read-out in the display window, and annunciator means arranged to indicate which parameter is currently being changed.

2. A digital meter as claimed in claim 1, in which the user can select directly with the prompt controls which parameter is to be altered without having to step through a menu.

3. A digital meter as claimed in claim 1 or 2, which permits the user to display, via said controls, a desired value for a given physical condition acting on said sensing means which is generating the electrical input signals.

4. A digital meter as claimed in any preceding claim, in which information to enable the user to perform a calibration routine is provided on the panel.

5. A digital meter as claimed in any preceding claim, in which the prompt controls comprise pushbuttons.

6. A digital meter as claimed in any preceding claim in which the annunciator means comprise a plurality of illuminable indicators respectively associated with parameters to be displayed.

7. A digital meter as claimed in any preceding claim, which also provides output alarm signals when a predetermined value of a parameter is reached or exceeded.

8. A digital meter as claimed in any preceding claim, in which the controls comprise pushbuttons which each have a primary and a secondary function.

9. A digital meter as claimed in claim 8, in which at least one of the pushbuttons also has a tertiary function.

10. A method of calibrating and/or adjusting a digital meter which is responsive to a physical variable to be monitored by sequentially displaying a value indication of parameters of the current condition of the variable, which comprises feeding electrical signals from sensing means to an input of the meter, operating prompt controls to follow a calibration routine or carry out adjustment using a digital read-out in a display window of the meter, and monitoring which parameter is currently being changed by using annunciator means respectively associated with different parameters.

11. A method as claimed in claim 10, which comprises using the prompt controls directly to select which parameter is to be altered without having to step through a menu.

12. A method as claimed in claim 10 or 11, which includes displaying a desired value for a given physical condition acting on the sensing means which is generating the input signals.
